# EUROPEAN PATENT APPLICATION

(11) **EP 4 641 923 A1**
(43) Date of publication of application: **29.10.2025**
(21) Application number: 24744099.3
(22) Date of filing: 05.01.2024
(51) Int. Cl.: H03B 5/04

(54) **MEMS OSCILLATOR AND ELECTRONIC DEVICE**

(30) Priority: 18.01.2023 CN 202310100846
(71) Applicant: Huawei Technologies Co., Ltd., Shenzhen, Guangdong 518129 (CN)
(72) Inventor: WU, Wei, Shenzhen, Guangdong 518129 (CN); GAO, Peng, Shenzhen, Guangdong 518129 (CN); LIU, Song, Shenzhen, Guangdong 518129 (CN); FENG, Zhihong, Shenzhen, Guangdong 518129 (CN); ZHANG, Lifeng, Shenzhen, Guangdong 518129 (CN)
(74) Representative: Goddar, Heinz J.
(86) International application number: PCT/CN2024/070821
(87) International publication number: WO 2024/152923

(57) **Abstract**

This application provides a MEMS (micro-electro-mechanical system, micro-electro-mechanical system) oscillator and an electronic device, and relates to the oscillator field, to improve frequency stability of the MEMS oscillator. The MEMS oscillator includes a first baseplate, a MEMS chip, and a second heater. The MEMS chip is disposed on the first baseplate, the MEMS chip includes a first MEMS resonator and a first heater, and the second heater is disposed outside the MEMS chip. The MEMS resonator is directly heated inside the MEMS chip by using the first heater, and is heated outside the MEMS chip by using the second heater. That is, internal heating and external heating are combined to implement internal and external dual-layer constant-temperature control.

## Description

This application claims priority to Chinese Patent Application No. 202310100846.1, filed with the China National Intellectual Property Administration on January 18, 2023 and entitled "MEMS OSCILLATOR AND ELECTRONIC DEVICE", which is incorporated herein by reference in its entirety.

### TECHNICAL FIELD

This application relates to the oscillator field, and in particular, to a micro-electro-mechanical system (MEMS) oscillator and an electronic device.

### BACKGROUND

Oscillators are required in most electronic products. The oscillator includes an electrical/mechanical resonator, a feedback network, an amplification network, and an output network. The oscillator uses a resonance feature of a circuit/mechanical component to implement frequency selection, and generate periodic oscillation clock signals.

An oven controlled crystal oscillator, abbreviated as OCXO (oven controlled crystal oscillator), is a crystal oscillator in which a quartz crystal resonator is placed in a thermostat to improve frequency and temperature features. The thermostat is used to keep a temperature of the quartz crystal resonator constant, and minimize a change of an oscillator output frequency due to an ambient temperature change. High stability of the OCXO has always been a goal pursued in the industry.

### SUMMARY

This application provides a MEMS oscillator and an electronic device, to improve frequency stability of the MEMS oscillator.

This application provides a MEMS oscillator. The oscillator includes a first baseplate, a MEMS chip, and a second heater. The MEMS chip is disposed on the first baseplate, the MEMS chip includes a first MEMS resonator and a first heater, and the second heater is disposed outside the MEMS chip. In this case, the MEMS resonator may be directly heated inside the MEMS chip by using the first heater, and may be heated outside the MEMS chip by using the second heater. That is, internal heating and external heating are combined to implement internal and external dual-layer constant-temperature control. The MEMS resonator can be precisely heated inside the MEMS chip directly by using the first heater to an inflection point temperature, so that heating efficiency can be improved, energy consumption can be reduced, and frequency stability can be improved. The MEMS resonator is externally heated from the outside of the MEMS chip by using the second heater, so that a surface temperature of the MEMS chip can be kept uniform and constant. In this way, the oscillator can well resist environmental interference, and frequency stability of the resonator is further improved.

In some possible implementations, the second heater includes a heating coil.

In some possible implementations, the MEMS chip is disposed in the middle relative to the second heater. In this way, the second heater may uniformly heat the MEMS chip from all sides.

In some possible implementations, the second heater is integrated on a surface of or inside the first baseplate.

In some possible implementations, the MEMS oscillator further includes a CMOS chip, and the CMOS chip is configured to control the MEMS chip; and the CMOS chip and the MEMS chip are disposed on different surfaces of the first baseplate; or the CMOS chip and the MEMS chip are stacked on a same surface of the first baseplate.

In some possible implementations, the second heater is integrated on a surface of the CMOS chip.

In some possible implementations, the MEMS oscillator includes a heating chip, the heating chip includes the second heater, and there is an overlapping region between projections of the heating chip and the MEMS chip on the first baseplate.

In some possible implementations, the heating chip is disposed on a surface of the first baseplate.

In some possible implementations, the heating chip is stacked on a surface of the CMOS chip.

In some possible implementations, the MEMS chip further includes a support beam located at a periphery of the first MEMS resonator; and the support beam is used as the first heater, or the first heater is disposed on a surface of the support beam.

In some possible implementations, the MEMS chip further includes a first temperature sensor, and the first temperature sensor is configured to detect a temperature of the first MEMS resonator.

In some possible implementations, the first temperature sensor is a second MEMS resonator arranged in parallel with the first MEMS resonator.

In some possible implementations, the MEMS oscillator further includes a first PID controller and a second PID controller. The first PID controller is configured to control power of the first heater based on a temperature measurement value obtained by the first temperature sensor. The second PID controller is configured to control power of the second heater based on an output value of the first PID controller, or the second PID controller is configured to control power of the second heater based on the temperature measurement value obtained by the first temperature sensor.

In some possible implementations, the MEMS oscillator further includes a second temperature sensor, the second temperature sensor is located outside the MEMS chip, and the second temperature sensor is configured to detect an external ambient temperature of the MEMS chip.

In some possible implementations, the oscillator further includes a first PID controller and a second PID controller. The first PID controller is configured to control power of the first heater based on a temperature measurement value obtained by the first temperature sensor. The second PID controller is configured to control power of the second heater based on a temperature measurement value obtained by the second temperature sensor.

In some possible implementations, the MEMS oscillator further includes a second baseplate and a packaging cap, a cavity is formed between the second baseplate and the packaging cap, and the first baseplate, the MEMS chip, and the second heater are all located on the second baseplate in the cavity.

In some possible implementations, the oscillator further includes a base, a packaging ring, and a packaging cover. The packaging ring is located between the base and the packaging cover, and a cavity is enclosed by the packaging ring, the packaging ring, and the packaging cover. The first baseplate, the MEMS chip, and the second heater are all located on the base in the cavity.

An embodiment of this application further provides an electronic device. The electronic device includes a circuit board and the MEMS oscillator provided in any one of the foregoing possible implementations. The MEMS oscillator is electrically connected to the circuit board.

### BRIEF DESCRIPTION OF DRAWINGS

FIG. 1 shows a frequency-temperature curve (namely, a TCF curve) of a MEMS resonator according to this application;
FIG. 2 is a diagram of a structure of a MEMS oscillator according to an embodiment of this application;
FIG. 3 is a diagram of an internal structure of a MEMS resonator according to an embodiment of this application;
FIG. 4 is a diagram of a structure of a MEMS resonator according to an embodiment of this application;
FIG. 5 is a diagram of a structure of a MEMS resonator according to an embodiment of this application;
FIG. 6 is a diagram of a structure of a first heater according to an embodiment of this application;
FIG. 7 is a diagram of an internal structure of a MEMS resonator according to an embodiment of this application;
FIG. 8 is a diagram of an internal structure of a MEMS resonator according to an embodiment of this application;
FIG. 9 is a diagram of an internal structure of a MEMS resonator according to an embodiment of this application;
FIG. 10 is a diagram of an internal structure of a MEMS resonator according to an embodiment of this application; and
FIG. 11 is a diagram of a structure of a MEMS oscillator according to an embodiment of this application.

### DESCRIPTION OF EMBODIMENTS

To make objectives, technical solutions, and advantages of this application clearer, the following clearly and completely describes the technical solutions in this application with reference to the accompanying drawings in this application. It is clear that the described embodiments are merely some rather than all of embodiments of this application. All other embodiments obtained by a person of ordinary skill in the art based on embodiments of this application without creative efforts shall fall within the protection scope of this application.

In the specification, embodiments, claims, and accompanying drawings of this application, the terms "first", "second", and the like are merely intended for distinguishing and description, and shall not be understood as indicating or implying relative importance, or indicating or implying a sequence. "At least one piece (item)" means one or more, and "a plurality of" means two or more. The term "and/or" is used for describing an association relationship between associated objects, and represents that three relationships may exist. For example, "A and/or B" may represent the following three cases: Only A exists, only B exists, and both A and B exist, where A and B may be singular or plural. The character "/" generally indicates an "or" relationship between the associated objects. "Installation", "connection", "being connected to", and the like should be understood in a broad sense, for example, may be a fixed connection, a detachable connection, or an integral connection; or may be a direct connection, an indirect connection through an intermediate medium, or internal communication between two elements. In addition, the terms "include", "have", and any variant thereof are intended to cover non-exclusive inclusion, for example, include a series of steps or units. A method, system, product, or device is not necessarily limited to those steps or units expressly listed, but may include other steps or units not expressly listed or inherent to such a process, method, product, or device. "On", "below", "left", "right", and the like are used only relative to an orientation of components in the accompanying drawings. These directional terms are relative concepts, are used for relative descriptions and clarifications, and may change accordingly as positions at which the components in the accompanying drawings are placed change.

First, related concepts in this application are explained and described.

MEMS (micro-electro-mechanical system, micro-electro-mechanical system): indicates a micro-electromechanical system that integrates a type sensor, an actuator, a signal processing unit, a control circuit, and a power supply on a micron-level chip according to a function requirement by using a micro-electromechanical processing technology.

Temperature coefficient of frequency (temperature coefficient of frequency, TCF): indicates a change of an inherent frequency of a corresponding resonator when a temperature of the resonator changes by 1°C in a determined temperature range.

An embodiment of this application provides an electronic device. The electronic device includes a MEMS oscillator and another device electrically connected to the MEMS oscillator, for example, a printed circuit board (printed circuit board, PCB, which may also be referred to as a circuit board) and a controller. This is not limited in this application. The another device may be disposed depending on an actual requirement and based on an actual scenario.

It may be understood that a resonator as an important component of the oscillator is mainly configured to generate a resonance frequency. Frequency stability of the resonator directly determines performance of the oscillator.

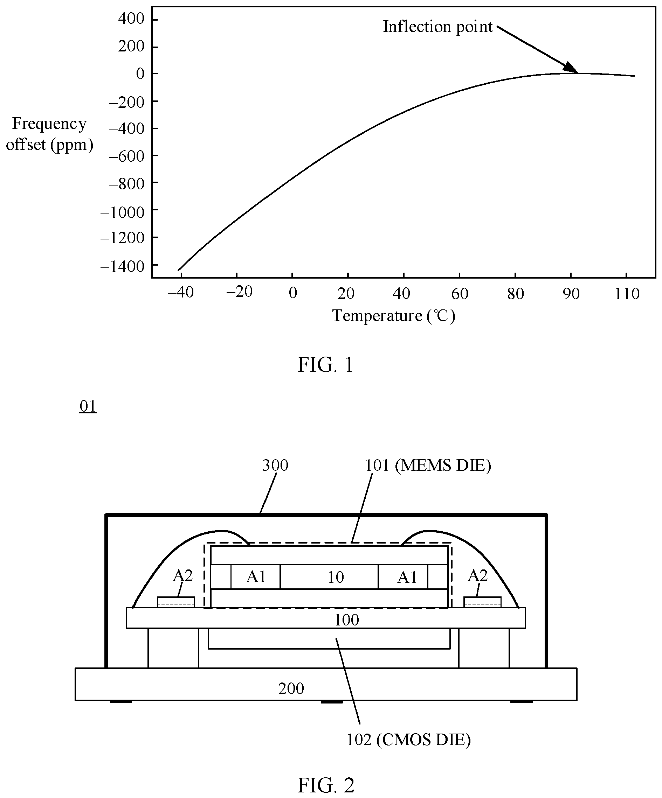

FIG. 1 shows a frequency-temperature curve (namely, a TCF curve) of a MEMS resonator. With reference to FIG. 1, at an inflection point of the TCF curve, when a temperature changes, a resonance frequency change (namely, a frequency offset) of the resonator is very small. Therefore, for an oven-controlled MEMS oscillator, a temperature of the resonator usually needs to be maintained at an inflection point temperature, to ensure stability of the oscillator.

In addition, for an electrostatic resonator, because of a problem of electrostatic negative stiffness, the resonator is very sensitive to fluctuation of an ambient temperature. For example, in some cases, when a temperature of an external baseplate fluctuates by 0.1°C, the frequency offset of the resonator may reach 3.1 ppb. Furthermore, a thermal stress caused by fluctuation of the ambient temperature also affects the resonance frequency of the MEMS resonator, and the frequency offset may reach more than 0.22 ppb/Mpa.

In view of this, an embodiment of this application provides a new type of oven-controlled MEMS oscillator (oven-controlled MEMS oscillator, OCMO). The oscillator uses internal and external dual-layer constant-temperature control, and has high frequency stability performance and a capability of resisting environmental interference.

An application field of the oscillator (OCMO) is not limited in this application. For example, the oscillator (OCMO) may be used in a data communication device, an optical transmission device, a BBU (building base band unit, building base band unit) of a base station, an RRU (radio remote unit, radio remote unit), and the like. The data communication device may include a server, a switch, a router, and the like. The optical transmission device may include an optical transport network (optical transport network, OTN) device, a passive optical network (passive optical network, PON), and the like.

For example, in the wireless communication field, the new type of oscillator provided in this embodiment of this application may be used in a BBU in a base station as a clock source, to ensure absolute time synchronization between all base stations in a wireless service. The new type of MEMS oscillator may also be used in a bearer network as a reference source of a synchronization network element, so that different base stations are synchronized through a network.

The following describes specific disposing of the new type of oscillator (OCMO) provided in this embodiment of this application.

For example, as shown in FIG. 2, an embodiment of this application provides a MEMS oscillator 01. The MEMS oscillator 01 includes a first baseplate 100 and a MEMS chip 101 (a MEMS DIE) that is disposed on the first baseplate 100. The MEMS chip 101 includes a MEMS resonator 10 (which may also be referred to as a first MEMS resonator) and first heaters A1. That is, the first heater A1 is manufactured by using a MEMS process, and is integrated in the MEMS DIE. In this case, the MEMS resonator 10 (or the MEMS resonator) may be directly heated inside the MEMS chip 101 by using the first heater A1. For example, the resonator may be heated to an inflection point temperature of a TCF curve. In this way, frequency stability of the resonator can be improved, heating efficiency can be further improved, and power consumption can be reduced.

Based on this, the MEMS oscillator 01 further includes second heaters A2 located outside the MEMS chip 101. The MEMS chip 101 is heated from the outside by using the second heater A2. When an external ambient temperature changes, it can be ensured that a surface temperature of the MEMS chip 101 is constant and uniform (that is, has a small temperature gradient). In this way, interference caused by an external local temperature change can be resisted, and frequency stability of the resonator is further improved.

In conclusion, for the MEMS oscillator 01 provided in this embodiment of this application, the first heater is disposed inside the MEMS chip 101 (MEMS DIE), and the second heater is disposed outside the MEMS chip, so that heating is separately performed inside and outside the MEMS chip, thereby implementing internal and external dual-layer constant-temperature control. In this case, the MEMS resonator 10 may be precisely heated inside the MEMS chip directly by using the first heater to an inflection point temperature, so that heating efficiency can be improved, energy consumption can be reduced, and frequency stability of the resonator can be improved. The MEMS resonator 10 is externally heated from the outside of the MEMS chip by using the second heater, so that a surface temperature of the MEMS chip is kept uniform and constant. In this way, the oscillator can well resist environmental interference, and frequency stability of the resonator is further improved.

The dual-layer constant-temperature oscillator in this application combines internal heating and external heating, and therefore has a wider operating temperature range. It may be understood that, under limited bit (bit) resources, a temperature control range and temperature control precision are mutually contradictory, and it is difficult to achieve both. If a disposing manner of dual-layer temperature control is adopted in this application, outer-layer temperature control is performed to cover a wide temperature range, but temperature control precision is slightly poor. For example, the baseplate may be heated from -40°C to 85°C-95°C. Inner-layer temperature control can be performed to increase a temperature of the resonator in a small range, to implement high-precision temperature control. For example, the resonator is heated from 85°C to 105°C or higher. The internal and external temperature control coordination manner can meet requirements of the oscillator for a wider operating temperature range and a high-temperature environment (for example, 105°C-125°C).

For example, in an existing technology, when a resonator is heated from the outside of a chip to a high-temperature inflection point (for example, above 105°C) by using an external heater, reliability of the chip is reduced, and high power consumption is introduced. If a dual-layer temperature control manner is adopted in this application, the resonator is first heated to a low temperature (for example, 85°C) by using the external second heater, and then the resonator is slightly heated inside the MEMS chip to an inflection point temperature by using the first heater, so that the oscillator not only can work in a high-temperature environment (for example, 105°C-125°C), but also has low power consumption.

In addition, in this application, disposing of outer-layer temperature control can ensure that a surface temperature of the MEMS DIE is constant, that is, a temperature gradient is small. Especially for a resonator with large electrostatic negative stiffness, a high requirement is imposed on stability of an ambient temperature outside the MEMS DIE, so that a problem of stability degradation of a resonator output frequency due to ambient temperature jitter is resolved.

In addition, for the MEMS oscillator provided in this embodiment of this application, a micro heater (A1) is integrated in the MEMS chip 101 by using a MEMS process, and wafer packaging is implemented, thereby ensuring a small size and high performance of the oscillator.

It should be noted that, in this embodiment of this application, the MEMS oscillator may be a single-crystal silicon oscillator, a polycrystalline silicon oscillator, a quartz crystal oscillator, an aluminum nitride oscillator, a lithium niobate oscillator, or the like. In other words, a resonator in the MEMS oscillator is made of single-crystal silicon, polycrystalline silicon, a quartz crystal, aluminum nitride, lithium niobate, or the like. This is not limited in this application.

Certainly, as shown in FIG. 2, another device such as the first baseplate 100 and a CMOS (complementary metal oxide semiconductor, complementary metal oxide semiconductor) chip 102 (namely, a CMOS DIE) may be further disposed in the MEMS oscillator 01. Both the MEMS chip 101 and the CMOS chip 102 are disposed on the first baseplate 100, and the MEMS chip 101 is electrically connected to the CMOS chip 102. A control circuit such as a temperature control circuit, a temperature compensation circuit, an oscillator circuit, and a frequency synthesizer is disposed in the CMOS chip 102, and can control the MEMS chip 101.

For example, the first baseplate 100 may be a circuit board, and the MEMS chip 101 and the CMOS chip 102 may be electrically connected to the first baseplate 100, so that the MEMS chip 101 and the CMOS chip 102 may be electrically connected through the first baseplate 100.

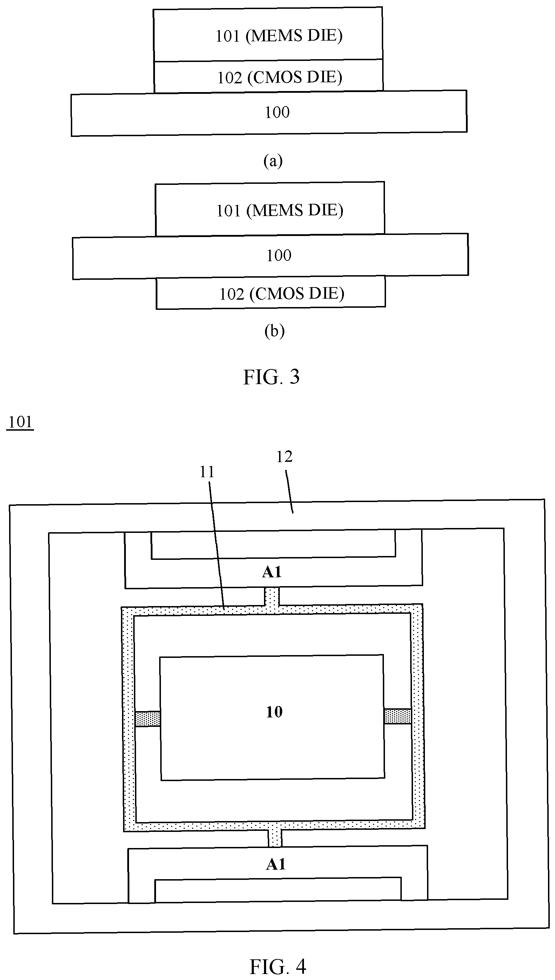

For a relative position relationship between the MEMS chip 101 and the CMOS chip 102 on the first baseplate 100, to reduce an area of the MEMS oscillator 01 as much as possible, in some possible implementations, as shown in FIG. 3, projections of the MEMS chip 101 and the CMOS chip 102 on the first baseplate 100 may be arranged to have an overlapping region. That is, the MEMS chip 101 and the CMOS chip 102 are disposed opposite to each other. For example, in some possible implementations, as shown in (a) in FIG. 3, the MEMS chip 101 and the CMOS chip 102 may be stacked on a surface of the first baseplate 100. For another example, in some possible implementations, as shown in (b) in FIG. 3, the MEMS chip 101 and the CMOS chip 102 are respectively disposed on two opposite different surfaces of the first baseplate 100, and positions of the MEMS chip 101 and the CMOS chip 102 are opposite to each other.

In addition, as shown in FIG. 4, in the MEMS chip 101, a support beam 11 is disposed at a periphery of the MEMS resonator 10, and the MEMS resonator 10 is connected to a substrate 12 through the support beam 11. A joint between the MEMS resonator 10 and the support beam 11 and a joint between the support beam 11 and the substrate 12 may be usually referred to as an anchor.

The following specifically describes related disposing of the first heater A1 and the second heater A2.

For disposing of the first heater A1:

For example, in some possible implementations, as shown in FIG. 4, the first heater A1 may be a metal coil structure disposed on a surface of the support beam 11.

For another example, in some possible implementations, the support beam 11 may be used as the first heater A1. For example, the support beam 11 may be obtained through etching on a heavily doped Si wafer (Wafer) (above 4.7e19/cm³) by using a deep reactive ion etching (deep reactive ion etching, DRIE) process, to implement a heating function through the support beam 11.

For another example, in some possible implementations, an insulation layer may be deposited on the support beam 11 by using an insulation material (for example, Si₃N₄, AlN, or SiO₂), and then a layer of polycrystalline silicon is deposited on the insulation layer as the first heater A1.

In this application, a shape, a quantity, and other settings of first heaters A1 are not limited, and may be set depending on an actual requirement.

Certainly, to ensure that the first heater A1 uniformly heats the MEMS resonator 10, in some possible implementations, first heaters A1 may be symmetrically disposed around all sides of the MEMS resonator 10, for example, disposed on a left side and a right side and on a front side and a rear side.

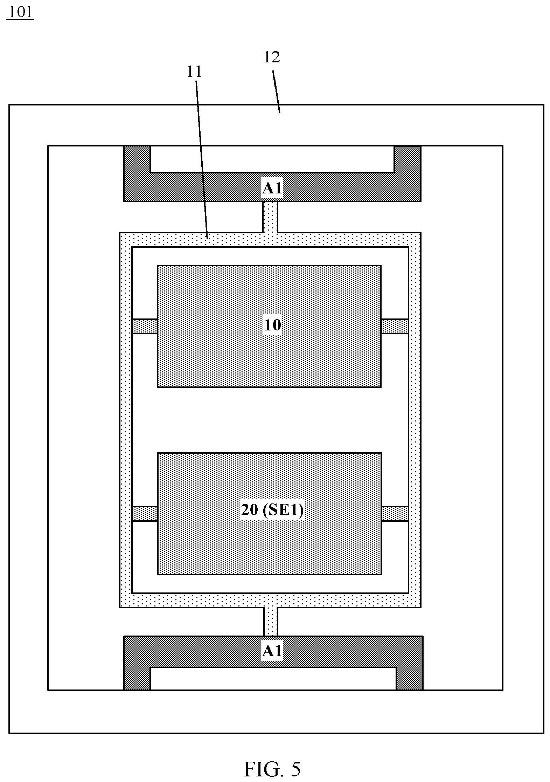

In addition, to measure a temperature of the MEMS chip 101, in some possible implementations, as shown in FIG. 5, a first temperature sensor SE1 may be disposed inside the MEMS chip 101, so that the temperature of the MEMS resonator 10 is detected by using the first temperature sensor SE1, to control power of the heaters (A1 and A2), thereby implementing constant-temperature control of the MEMS resonator 10.

A disposing form of the first temperature sensor SE1 is not limited in this application, and may be set depending on an actual requirement.

For example, as shown in FIG. 5, in some possible implementations, the first temperature sensor SE1 may use a disposing manner of a MEMS resonator. Two MEMS resonators may be arranged in parallel inside the MEMS chip 101, namely, the MEMS resonator 10 (a first MEMS resonator) and a MEMS resonator 20 (a second MEMS resonator). The MEMS resonator 10 is configured to output a working clock signal. The MEMS resonator 20 is used as the first temperature sensor SE1. A clock signal output by the MEMS resonator 20 is used to detect the temperature of the MEMS resonator 10. The temperature of the MEMS resonator 10 may be reversely calculated by measuring a frequency difference between the MEMS resonator 20 and the MEMS resonator 10.

For example, for the two MEMS resonators (10 and 20) in the MEMS chip 101, the two MEMS resonators (10 and 20) have close resonance frequencies, but the two MEMS resonators have different TCF curves. A TCF of the MEMS resonator 20 is very large, for example, 10 ppm/C, and the TCF curve is relatively linear. However, a TCF of the MEMS resonator 10 is small, for example, 1 ppm/C, and the TCF curve is of a parabolic shape, that is, has an inflection point temperature. For example, the inflection point temperature of the MEMS resonator 10 is 105°C-125°C, and the TCF is less than 0.1 ppm/C within a deviation of 1°C (namely, ±1°C) of the inflection point temperature.

### For disposing of the second heater A2:

First, a disposing form of the second heater A2 is not limited in this application, and may be set depending on an actual requirement.

For example, in some possible implementations, the second heater A2 may be a micro heater. For example, the micro heater may be made of a material such as platinum (Pt), gold (Au), silver (Ag), nichrome (NiCr), nickel (Ni), tungsten (W), titanium (Ti), aluminum (Al), copper (Cu), graphene, carbon nanotube (CNT), titanium nitride (TiN), gallium nitride (GaN), gallium arsenide (GaAs), nickel-cobalt-iron alloy (NiCoFe alloy), and polycrystalline silicon (Poly-Si), and a thin layer coil is deposited on the baseplate by using a micromachining process. For example, the second heater A2 may be directly integrated on a surface of or inside the first baseplate 100, or may be integrated on a surface of the CMOS chip 102.

For another example, in some possible implementations, the second heater A2 may be a micro-heating chip, a thin film heater, or the like.

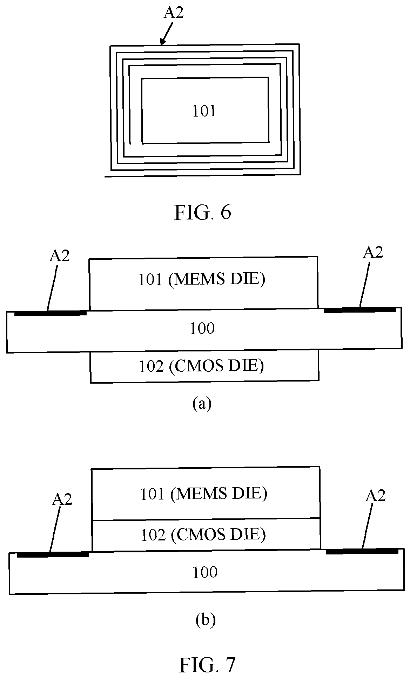

Certainly, to ensure that the second heater A2 uniformly heats the MEMS chip 101, in some possible implementations, with reference to FIG. 6, the MEMS chip 101 may be disposed in the middle relative to the second heater A2. In other words, central regions of projections of the second heater A2 and the MEMS chip 101 on the first baseplate 100 overlap or approximately overlap. In this way, the second heater A2 may uniformly heat the MEMS chip 101 from all sides.

A shape of a heating element in the second heater A2 is not limited in this application. The heating element may be of a simple line pattern, or may be of a complex irregular pattern, or the like, to provide uniform heat distribution for the MEMS chip 101.

The following specifically describes disposing positions of the second heater A2 in different disposing manners.

### Disposing manner 1

As shown in FIG. 7, in some possible implementations, the second heater A2 may be directly integrated on a surface of the first baseplate 100. In this case, the MEMS chip 101 and the CMOS chip 102 may be disposed depending on an actual requirement.

For example, in some possible implementations, as shown in (a) in FIG. 7, the MEMS chip 101 and the CMOS chip 102 are respectively disposed on two opposite different surfaces of the first baseplate 100.

For another example, in some possible implementations, as shown in (b) in FIG. 7, the MEMS chip 101 and the CMOS chip 102 may be stacked on a surface of the first baseplate 100, and the MEMS chip 101 is located on a side that is of the CMOS chip 102 and that is away from the first baseplate 100.

In the disposing manner 1, the second heater A2 is integrated on the surface of the first baseplate 100, so that the MEMS chip 101 is heated by heating the first baseplate 100.

FIG. 7 is merely an example in which second heaters A2 are distributed in a peripheral region of the MEMS chip 101. To be specific, an example in which projections of the second heater A2 and the MEMS chip 101 on the first baseplate 100 do not overlap is used for description. However, this application is not limited thereto. In some other possible implementations, there may be an overlapping region between projections of the second heater A2 and the MEMS chip 101 on the first baseplate 100. This is not limited in this application, and may be set depending on an actual requirement.

Certainly, in another possible implementation, the second heater A2 may be directly integrated inside the first baseplate 100. For details about the MEMS chip 101 and the CMOS chip 102, refer to FIG. 7 and the corresponding text descriptions.

### Disposing manner 2

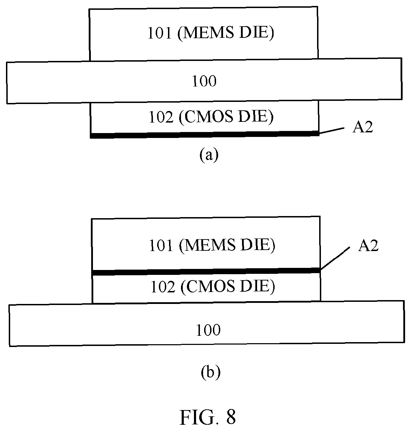

As shown in FIG. 8, in some possible implementations, the second heater A2 may be directly integrated on a surface of the CMOS chip 102. For example, the second heater A2 may be directly integrated on a surface that is of the CMOS chip 102 and that is away from a side of the first baseplate 100. In this case, a position of the MEMS chip 101 may be set depending on an actual requirement.

For example, in some possible implementations, as shown in (a) in FIG. 8, the MEMS chip 101 and the CMOS chip 102 are respectively disposed on two opposite different surfaces of the first baseplate 100. In this case, the second heater A2 may heat the MEMS chip 101 by heating the first baseplate 100.

For another example, in some possible implementations, as shown in (b) in FIG. 8, the MEMS chip 101 may be directly stacked on a surface on which the second heater A2 is disposed on the CMOS chip 102, so that the second heater A2 can heat the MEMS chip 101 from the bottom of the MEMS chip 101.

### Disposing manner 3

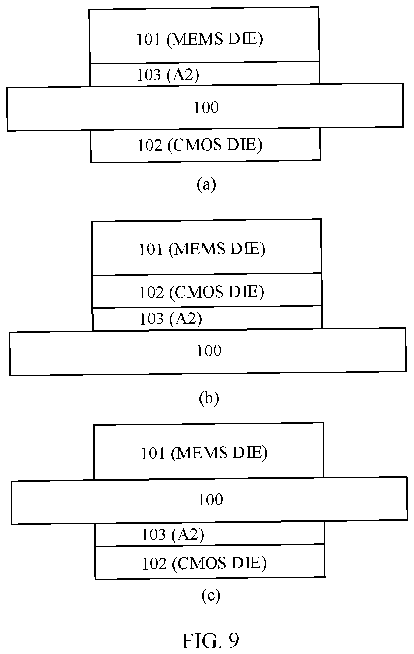

As shown in FIG. 9, in some possible implementations, the second heater A2 uses a heating chip 103, and the heating chip 103 may be directly disposed on a surface of the first baseplate 100. In this case, relative positions of the MEMS chip 101 and the CMOS chip 102 may be set depending on an actual requirement.

For example, in some possible implementations, as shown in (a) in FIG. 9, the heating chip 103 is disposed on an upper surface of the first baseplate 100, the MEMS chip 101 is stacked on an upper surface of the heating chip 103, and the CMOS chip 102 is disposed on a lower surface of the first baseplate 100, so that the heating chip 103 directly heats the MEMS chip 101 from the bottom.

For another example, in some possible implementations, as shown in (b) in FIG. 9, the heating chip 103 is disposed on an upper surface of the first baseplate 100, the CMOS chip 102 is stacked on an upper surface of the heating chip 103, and the MEMS chip 101 is stacked on an upper surface of the CMOS chip 102, so that the heating chip 103 first heats the CMOS chip 102 and then heats the MEMS chip 101.

For another example, in some possible implementations, as shown in (c) in FIG. 9, the MEMS chip 101 is disposed on an upper surface of the first baseplate 100, the heating chip 103 is disposed on a lower surface of the first baseplate 100, the CMOS chip 102 is stacked on a lower surface of the heating chip 103, so that the heating chip 103 heats the MEMS chip 101 by heating the first baseplate 100.

### Disposing manner 4

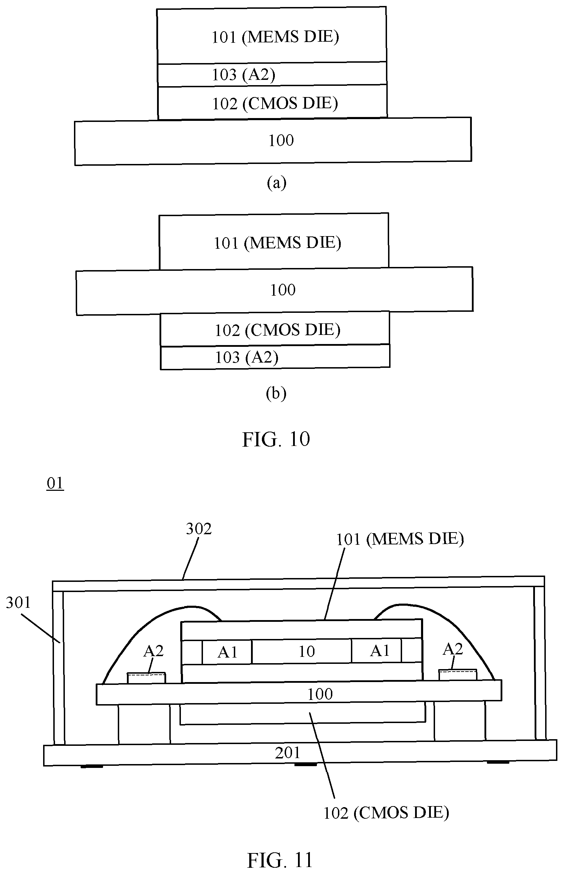

As shown in FIG. 10, in some possible implementations, the second heater A2 uses a heating chip 103, and the heating chip 103 may be stacked on a surface of the CMOS chip 102. For example, the heating chip 103 may be stacked on a surface that is of the CMOS chip 102 and that is away from a side of the first baseplate 100. In this case, relative positions of the MEMS chip 101 and the CMOS chip 102 may be set depending on an actual requirement.

For example, in some possible implementations, as shown in (a) in FIG. 10, the CMOS chip 102 is disposed on an upper surface of the first baseplate 100, the heating chip 103 is stacked on an upper surface of the CMOS chip 102, and the MEMS chip 101 is stacked on an upper surface of the heating chip 103, so that the heating chip 103 directly heats the MEMS chip from the bottom.

For another example, in some possible implementations, as shown in (b) in FIG. 10, the CMOS chip 102 is disposed on a lower surface of the first baseplate 100, the heating chip 103 is stacked on a lower surface of the CMOS chip 102, and the MEMS chip 101 is disposed on an upper surface of the first baseplate 100, so that the heating chip 103 heats the CMOS chip 102 and the first baseplate 100, and then heats the MEMS chip 101.

The following describes dual temperature control of the MEMS resonator 10 inside the MEMS chip 101 with reference to the first heater A1 and the second heater A2.

For example, a first PID controller and a second PID controller may be disposed in the MEMS oscillator 01. The first PID controller and the second PID controller respectively control power of the first heater A1 and the second heater A2, so that a temperature of the MEMS resonator 10 is maintained at an inflection point temperature, thereby ensuring stability of the oscillator.

For example, the first PID controller may adjust an output electrical signal (for example, a voltage signal or a current signal) based on a temperature measurement value obtained by the first temperature sensor SE1 disposed inside the MEMS chip 101, to control the power of the first heater A1.

### For the second PID controller:

For example, in some possible implementations, in the MEMS oscillator 01, a second temperature sensor may be disposed outside the MEMS chip 101, and an external ambient temperature of the MEMS chip 101 is detected by using the second temperature sensor. A disposing manner and a specific position of the second temperature sensor may be set according to a requirement, provided that a requirement for external temperature measurement of the MEMS chip 101 is met. This is not limited in this application. In this case, the second PID controller may adjust an output electrical signal (for example, a voltage signal or a current signal) based on a temperature measurement value obtained by the second temperature sensor, to control the power of the second heater 102.

For example, in some possible implementations, in the MEMS oscillator 01, in a case in which no additional temperature sensor is disposed outside the MEMS chip 101, in some embodiments, the second PID controller may control the power of the second heater A2 based on an output value of the first PID controller; or in some embodiments, the second PID controller may adjust an output electrical signal (for example, a voltage signal or a current signal) based on the temperature measurement value obtained by the first temperature sensor SE1 inside the MEMS chip 101, to control the power of the second heater A2.

For example, for the MEMS oscillator 01 shown in FIG. 2, in some embodiments, the second PID controller may control the power of the second heater A2, to heat the first baseplate 100 to 85°C-95°C. Correspondingly, in this case, the temperature of the MEMS resonator 10 in the MEMS chip 101 is initially increased to 85°C-95°C. Then, the first PID controller may control the power of the first heater A1, and the MEMS resonator 10 inside the MEMS chip 101 is further heated to 105°C-125°C, so that the MEMS oscillator 01 not only can work at a high temperature, but also has low power consumption.

In addition, a packaging manner of the MEMS oscillator 01 is not limited in this application. A proper packaging manner may be selected depending on an actual requirement and based on an actual application scenario.

For example, in some possible implementations, as shown in FIG. 2, the MEMS oscillator 01 may further include a second baseplate 200 and a packaging cap 300. Devices such as the first baseplate 100, the MEMS chip 101, and the second heater 102 are all located on the second baseplate 200 and are electrically connected to the second baseplate 200, to implement interconnection and communication with an external device through the second baseplate 200. The packaging cap 300 is disposed on the second baseplate 200, and is located on outer sides of devices such as the first baseplate 100, the MEMS chip 101, and the second heater 102. A cavity is formed between the packaging cap 300 and the second baseplate 200, so that the devices such as the first baseplate 100, the MEMS chip 101, and the second heater 102 are packaged inside the cavity, that is, an enclosed environment is formed outside the MEMS chip 101. For example, the second baseplate 200 may be a circuit board, but this is not limited thereto.

For another example, in some possible implementations, as shown in FIG. 11, the MEMS oscillator 01 further includes a base 201, a packaging ring 301, and a packaging cover 302. The devices such as the first baseplate 100, the MEMS chip 101, and the second heater 102 are all located on the base 201, and are electrically connected to the base 201, to implement interconnection and communication with an external device through the base 201. The packaging ring 301 is disposed on the base 201, and is located on the outer sides of the devices such as the first baseplate 100, the MEMS chip 101, and the second heater 102. The packaging cover 302 covers the top of the packaging ring 301. In this case, a cavity is enclosed by the packaging cover 302, the packaging ring 301, and the base 201, so that the devices such as the first baseplate 100, the MEMS chip 101, and the second heater 102 are packaged inside the cavity, that is, an enclosed environment is formed outside the MEMS chip 101. For example, the base 201 may be a ceramic base, but this is not limited thereto.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A MEMS oscillator, comprising:
a first baseplate;
a MEMS chip, wherein the MEMS chip is disposed on the first baseplate, and the MEMS chip comprises a first MEMS resonator and a first heater; and
a second heater, wherein the second heater is disposed outside the MEMS chip.

2. The MEMS oscillator according to claim 1, wherein
the second heater comprises a heating coil.

3. The MEMS oscillator according to claim 1 or 2, wherein
the MEMS chip is disposed in the middle relative to the second heater.

4. The MEMS oscillator according to any one of claims 1 to 3, wherein
the second heater is integrated on a surface of or inside the first baseplate.

5. The MEMS oscillator according to any one of claims 1 to 3, wherein
the MEMS oscillator further comprises a CMOS chip, and the CMOS chip is configured to control the MEMS chip; and
the CMOS chip and the MEMS chip are disposed on different surfaces of the first baseplate, or the CMOS chip and the MEMS chip are stacked on a same surface of the first baseplate.

6. The MEMS oscillator according to claim 5, wherein
the second heater is integrated on a surface of the CMOS chip.

7. The MEMS oscillator according to any one of claims 1 to 5, wherein
the MEMS oscillator comprises a heating chip, the heating chip comprises the second heater, and there is an overlapping region between projections of the heating chip and the MEMS chip on the first baseplate.

8. The MEMS oscillator according to claim 7, wherein
the heating chip is disposed on a surface of the first baseplate; or
the heating chip is stacked on a surface of the CMOS chip.

9. The MEMS oscillator according to any one of claims 1 to 8, wherein
the MEMS chip further comprises a support beam located at a periphery of the first MEMS resonator; and
the support beam is used as the first heater, or the first heater is disposed on a surface of the support beam.

10. The MEMS oscillator according to any one of claims 1 to 9, wherein
the MEMS chip further comprises a first temperature sensor, and the first temperature sensor is configured to detect a temperature of the first MEMS resonator.

11. The MEMS oscillator according to claim 10, wherein
the first temperature sensor is a second MEMS resonator arranged in parallel with the first MEMS resonator.

12. The MEMS oscillator according to claim 10, wherein
the MEMS oscillator further comprises a first PID controller and a second PID controller;
the first PID controller is configured to control power of the first heater based on a temperature measurement value obtained by the first temperature sensor; and
the second PID controller is configured to control power of the second heater based on an output value of the first PID controller, or the second PID controller is configured to control power of the second heater based on the temperature measurement value obtained by the first temperature sensor.

13. The MEMS oscillator according to claim 10 or 11, wherein
the MEMS oscillator further comprises a second temperature sensor, the second temperature sensor is located outside the MEMS chip, and the second temperature sensor is configured to detect an external ambient temperature of the MEMS chip.

14. The MEMS oscillator according to claim 13, wherein
the oscillator further comprises a first PID controller and a second PID controller;
the first PID controller is configured to control power of the first heater based on a temperature measurement value obtained by the first temperature sensor; and
the second PID controller is configured to control power of the second heater based on a temperature measurement value obtained by the second temperature sensor.

15. The MEMS oscillator according to any one of claims 1 to 14, wherein
the MEMS oscillator further comprises a second baseplate and a packaging cap;
a cavity is formed between the second baseplate and the packaging cap; and
the first baseplate, the MEMS chip, and the second heater are all located on the second baseplate in the cavity.

16. The MEMS oscillator according to any one of claims 1 to 14, wherein
the oscillator further comprises a base, a packaging ring, and a packaging cover;
the packaging ring is located between the base and the packaging cover, and a cavity is enclosed by the packaging ring, the packaging ring, and the packaging cover; and
the first baseplate, the MEMS chip, and the second heater are all located on the base in the cavity.

17. An electronic device, comprising a circuit board and the MEMS oscillator according to any one of claims 1 to 16, wherein the MEMS oscillator is electrically connected to the circuit board.
